(19) Europäisches Patentamt

European Patent Office

Office européen des brevets

(11) **EP 1 724 817 A1**

(12) **EUROPEAN PATENT APPLICATION**
published in accordance with Art. 158(3) EPC

(43) Date of publication:
**22.11.2006 Bulletin 2006/47**

(51) Int Cl.:
*H01L 21/205* (2006.01)   *C23C 16/448* (2006.01)
*H01L 21/31* (2006.01)

(21) Application number: **05709899.8**

(22) Date of filing: **08.02.2005**

(86) International application number:
**PCT/JP2005/001847**

(87) International publication number:
**WO 2005/078781 (25.08.2005 Gazette 2005/34)**

(84) Designated Contracting States:
**DE FR GB IT NL**

(30) Priority: **12.02.2004 JP 2004035527**

(71) Applicant: **TOKYO ELECTRON LIMITED**
**Minato-ku,**
**Tokyo 107-8481 (JP)**

(72) Inventors:
• **IWATA, Teruo**
  **Minato-ku**
  **Tokyo 107-8481 (JP)**

• **AMIKURA, Manabu**
  **Minato-ku**
  **Tokyo 107-8481 (JP)**
• **FUTAMURA, Munehisa**
  **Minato-ku**
  **Tokyo 107-8481 (JP)**
• **TAKAHASHI, Tsuyoshi**
  **Minato-ku**
  **Tokyo 107-8481 (JP)**

(74) Representative: **Schrell, Andreas et al**
**Gleiss Grosse Schrell & Partner**
**Patentanwälte Rechtsanwälte**
**Leitzstrasse 45**
**70469 Stuttgart (DE)**

(54) **FILM FORMING APPARATUS**

(57)   A film forming apparatus according to the present invention has a source material supply section, a vaporizer, and a film forming chamber. The vaporizer comprises a nozzle which spays the liquid material supplied from the source material supply section, a vaporization chamber which has one end in which the nozzle opens and a closed other end and in which the misty liquid material sprayed through the nozzle is vaporized to generate the material gas, a heater which heats the vaporization chamber, and an outlet port which opens in the vaporization chamber in the vicinity of the nozzle and through which the material gas is discharged from the vaporization chamber. The closed other end of the vaporization chamber is kept at a long enough distance from the nozzle to allow the liquid source material injected through the nozzle to vaporize.

FIG. 3A

**Description**

Technical Field

The present invention relates to a film forming apparatus for forming a dielectric film, metal film, semiconductor film, etc., and more particularly, to a vaporizer of a film forming apparatus.

Background Art

Described in Jpn. Pat. Appln. KOKAI Publications Nos. 6-310444 and 7-94426, for example, is a chemical vapor deposition (CVD) method in which an organic source material (organic metallic compound, etc.) is reacted with any other gas (oxygen, ammonia, etc.) in a film forming chamber to form a dielectric film, metal film, semiconductor film, etc. Many organic materials are liquid or solid at room temperature and atmospheric pressure, so that a film forming apparatus comprises a vaporizer for vaporizing organic materials. For example, an organic material turn into liquid by being diluted or dissolved with a solvent or the like. Then, the liquid organic material is sprayed into the vaporization chamber through a nozzle, whereupon the organic material is vaporized into a source material gas. This source material gas is introduced into the film forming chamber and reacts with another gas therein so that a film component is deposited on a substrate.

A large number of particles are produced as an organic source material mist that is sprayed through the nozzle of the vaporizer is vaporized. The particles include ones that are derived from residual components in the remaining organic material left after the solvent is volatilized or ones that are derived from decomposition products as a result of decomposition of the organic material. These particles are deposited on the spray nozzle, the inner surface of the vaporization chamber, a filter, the interior of a gas transport pipe, etc., thereby clogging various parts of the vaporizer. Along with the source material gas, moreover, the particles reach the film forming chamber and cause abnormal film formation or production of low-quality films.

In order to solve the above problem, conventional film forming apparatuses are provided with various countermeasures for particles. As a measure to reduce particles and enhance the quality level of film formation, for example, the mixture ratio between a liquid source material and a carrier gas in the spray nozzle may possibly be increased or a filter for trapping may be provided at an outlet port of the vaporizer or in the middle of the gas transport pipe. If this is done, however, the nozzle and the filter are clogged, so that the concentration and pressure of the source material are liable to variation, and maintenance and inspection work, such as cleaning or replacement of the filter, must be carried out frequently. Therefore, the maintenance and inspection of the apparatus and the management of film forming conditions are burdensome, so that the productivity lowers.

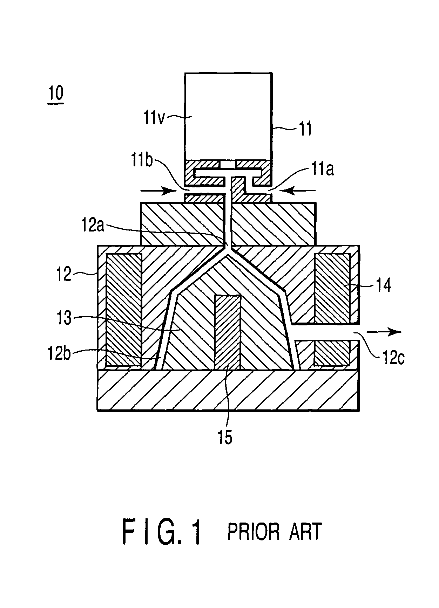

A vaporizer of a conventional apparatus will now be described with reference to FIG. 1. The vaporizer 10 comprises an inlet portion 11, external block 12, internal block 13, nozzle portion 12a, vaporization chamber 12b, and outlet portion 12c. The inlet portion 11 is provided with a source material inlet port 11a, a carrier gas supply port 11b, a passage that opens into the nozzle portion 12a, and an on-off valve 11v in the passage. When the valve 11v is opened, a liquid organic source material and a carrier gas are introduced into the passage through the source material inlet port 11a and the carrier gas supply port 11b, respectively. The organic source material and the carrier gas are mixed in the passage, and the resulting gas-liquid mixture is injected into the vaporization chamber 12b through the nozzle portion 12a. The external and internal blocks 12 and 13 are provided with heaters 14 and 15, respectively. The mist that is injected through the nozzle portion 12a is heated and vaporized into a source material gas, which is discharged into a film forming chamber (not shown) through the outlet portion 12c.

Since the conventional vaporization chamber 12b is narrow, however, the mist sprayed through the nozzle portion 12a cannot be fully vaporized before it reaches the respective inner wall surfaces of the external and internal blocks 12 and 13. Since the mist directly touches the inner wall surfaces of the blocks 12 and 13, moreover, the wall surface temperatures of the blocks 12 and 13 lower. Thereupon, only the solvent is volatilized before the organic source material in the mist is fully heated. In consequence, a solid matter of the source material adherently remains on the nozzle portion 12a and the inner wall surface of the vaporization chamber 12b (inner wall surface of the internal block 13). When it peel off the wall surface, the solid matter turn into particles. These particles adhere to a wafer in the film forming chamber and lower the film quality. Accordingly, the conventional film forming apparatus requires frequent cleaning, that is, continual maintenance.

Thus, the conventional film forming apparatus cannot satisfactorily deal with particles and is subject to problems of low film quality and frequency maintenance.

Disclosure of Invention

The object of the present invention is to provide a film forming apparatus capable of reducing production of particles, ensuring improved film quality, and lowering the frequency of maintenance.

A film forming apparatus according to the present invention has a source material supply section which supplies a liquid source material, a vaporizer which vaporizes the liquid source material to generate a source material gas, and a film forming chamber into which the source material gas is introduced to form a thin film on a substrate to be processed. The vaporizer comprises a spray nozzle which spays the liquid source material supplied from the source material supply section, a vaporization chamber which has one end portion in which the spray nozzle opens and a closed other end portion and in which the misty liquid source material sprayed through the spray nozzle is vaporized to generate the source material gas, heating means which heats the vaporization chamber, and an outlet port which opens in the vaporization chamber in the vicinity of the spray nozzle and through which the source material gas is discharged from the vaporization chamber, the closed other end portion of the vaporization chamber being kept at a long enough distance from the spray nozzle to allow the liquid source material injected through the spray nozzle to vaporize.

According to the present invention, a source material mist can be flown for a long distance in the vaporization chamber. While the source material mist is flying in the vaporization chamber, it can be fully heated by radiant and conductive heat from the inner surface of the vaporization chamber. Thus, the source material mist can be fully vaporized before it reaches the inner surface of the vaporization chamber, so that the vaporization efficiency is enhanced, and production of particles can be reduced.

A longitudinal length H1 of the vaporization chamber is adjusted to a length such that the source material mist cannot reach the inner wall of the closed other end portion of the vaporization chamber. If the length H1 is long enough, the source material mist can be completely vaporized in the vaporization chamber, so that production of particles can be prevented securely.

The ratio (H1/D1) between the longitudinal length H1 and a diameter D1 of the vaporization chamber preferably ranges from 2.5 to 6.0, and more preferably from 3.5 to 5.0. The length H1 is a length from a jet of the spray nozzle to a peripheral wall of the closed other end portion. The diameter D1 is a maximum inside diameter of the vaporization chamber or an average inside diameter from a middle position in the vaporization chamber to the other end portion. Preferably, moreover, the cross-sectional shape of the vaporization chamber is truly or equivalently circular.

The substantially uniform inside diameter is equivalent to the inside diameter D1 if the inside diameter of the vaporization chamber gradually increases with distance from the spray nozzle at the one end portion side of the vaporization chamber, and if the inside diameter of that part of the vaporization chamber which extends from the outlet port to the other end portion is substantially uniform. Further, the maximum inside diameter in the middle position is equivalent to the inside diameter D1 if the inside diameter of the vaporization chamber gradually increases with distance from the spray nozzle at the one end portion side of the vaporization chamber, if the inside diameter has a maximum value in a middle position in the vaporization chamber, and if the inside diameter of that part which extends from the middle position to the other end portion gradually degreases. If the inside diameter of that part of the vaporization chamber which extends from the one end portion to the other end portion thereof is substantially uniform, moreover, the substantially uniform inside diameter is equivalent to the inside diameter D1.

Preferably, according to the present invention, the heating means is located in a peripheral wall which defines the other end portion of the vaporization chamber and heats the other end portion of the vaporization chamber so that the temperature on the other end portion side of the vaporization chamber is higher than the temperature on the one end portion side. More specifically, the heating means has a proximal-end-side heater which heats one end side (spray nozzle side) of the vaporization chamber and a distal-end-side heater which heats the closed other end portion of the vaporization chamber. A set temperature for the distal-end-side heater is set higher than a set temperature for the proximal-end-side heater. Preferably, moreover, the apparatus comprises a heat transfer restricting structure which restricts heat transfer between the one end portion and the other end portion of the vaporization chamber. The heat transfer restricting structure may be any structure that can form a temperature difference between the spray nozzle side and its opposite side. For example, the heat transfer restricting structure may be a structure in which a difference is provided between the cross section of a member that constitutes the spray-nozzle-side part of the vaporization chamber and that of a member that constitutes the opposite-side part, a structure in which a boundary portion is provided having a cross section smaller than that of the spray-nozzle-side part and/or the opposite-side part of the vaporization chamber, or a structure in which a material having higher heat insulating properties than a material that forms the inner surface of the vaporization chamber is interposed between the spray-nozzle-side part and the opposite-side part of the vaporization chamber. Preferably, furthermore, the spray nozzle is embedded in a peripheral wall of the vaporization chamber on the one end portion side thereof, and the apparatus further comprises a heat insulating member which thermally insulates the spray nozzle from the peripheral wall.

With this arrangement, the quantity of heat transferred to the spray nozzle can be reduced, and the liquid source material can be prevented from boiling before it is sprayed and from varying in the flow rate. Accordingly, the liquid source material can be steadily fed into the vaporization chamber and prevented from being decomposed or deposited. By raising the temperature on the opposite side from the spray nozzle, moreover, the source material mist sprayed through the spray nozzle can be vaporized independently at a distance from the nozzle. Thus, the vaporization efficiency can be enhanced additionally, and production of particles can be reduced further.

Preferably, according to the present invention, the outlet port is situated nearer to the spray nozzle than a middle position between the one end portion and the other end portion of the vaporization chamber and opens in a side peripheral wall of the vaporization chamber. Since the outlet port thus opens in that part of the side peripheral surface which is situated nearer to the spray nozzle than the middle position with respect to the longitudinal direction of the vaporization chamber (or the spray direction), the mist that is sprayed through the spray nozzle on the extended distal end side can be restrained from directly reaching the outlet port. By utilizing the extended shape of the vaporization chamber, moreover, the mist can be vaporized mainly in a place that is more distant in the spray direction from the nozzle than the outlet port. Thus, the mist can be vaporized before particles that are produced in the vaporization chamber reach the outlet port, so that production of particles and their discharge on the downstream side can be reduced.

Preferably, the spray nozzle has a source material jet through which the liquid source material is ejected and an annular gas jet which is located adjacent to the periphery of the source material jet and through which a carrier gas is ejected, and the direction of ejection of the liquid source material through the source material jet is substantially the same as the direction of ejection of the carrier gas through the gas jet. With this arrangement, the carrier gas is supplied through the source material jet and the adjacent annular gas jet of the spray nozzle, which have substantially the same ejection direction, whereby the liquid source material ejected through the source material jet can be sprayed in the vicinity of the nozzle. The carrier gas allows the mist to be vaporized without easily reaching the inner side face of the vaporization chamber. Further, the liquid source material ejected through the source material jet and the carrier gas ejected through the gas jet can cause the mist to reach a position at a certain distance from the spray nozzle with respect to the extension direction of the vaporization chamber. Accordingly, the place where the mist is vaporized can be restricted to a region at a distance in the spray direction from the nozzle. Thus, the source material can be efficiently sprayed into a mist and fully vaporized, so that the rate of particle production can be reduced, and the produced particles can be prevented from being easily discharged through the outlet port.

Preferably, only the liquid source material is ejected from the source material jet. According to this arrangement, only the liquid source material can be ejected from the source material jet, so that solid matters can be prevented from being deposited in the nozzle and clogging it when the liquid source material in a gas-liquid mixture state is sprayed through the spray nozzle, as in the conventional case. Thus, the supply of the liquid source material can be stabilized.

Preferably, the closed other end portion of the vaporization chamber is concaved. This shape of the other end portion can make it hard for the mist sprayed through the spray nozzle to reach the inner wall surface directly and also prevent the mist from intensively colliding against the central part of the inner wall surface. Thus, the state of vaporization can be stabilized further.

Preferably, according to the present invention, the apparatus further comprises an additional carrier gas inlet portion through which a carrier gas is additionally supplied to a passage between the vaporizer and the film forming chamber. According to results of various experiments repeatedly conducted by the inventors hereof, the amount of particles that flow into the film forming chamber increases if the ratio between the liquid source material and the carrier gas introduced into the vaporization chamber lowers, that is, if the amount of the carrier gas increases relatively. This increase of the amount of particles is supposed to be attributable to an increase of the degree of scatter of the liquid source material caused by the carrier gas in the spray nozzle, which causes direct scatter of the source material mist in the vicinity of the outlet port, or to enhancement of gas temperature lowering by adiabatic expansion of the carrier gas near the nozzle, which lowers the source material vaporization efficiency.

If the carrier gas amount is reduced extremely, however, the spray speed lowers, so that it is hard for the source material mist to reach the region on the high-temperature side (opposite from the spray nozzle) of the vaporization chamber. Therefore, the mist is discharged directly from the vaporization chamber through only the region on the low-temperature side (nozzle side). Since the source material mist can thus easily reach the film forming chamber without being fully vaporized in the vaporization chamber, production of particles on a wafer increases. If the flow rate of the carrier gas is lowered, moreover, the source material gas cannot be uniformly dispersed in a showerhead, so that it is hard to keep the within-wafer uniformity of film formation.

Since the additional carrier gas inlet portion is provided between the vaporizer and the film forming chamber, the rate of introduction of the carrier gas into the vaporization chamber can be set to a suitable value for vaporization, and the rate of introduction into the showerhead can be increased. Thus, production of particles in the vaporization chamber can be reduced, and the vaporized source material gas can be properly dispersed in the showerhead, so that the within-wafer uniformity of film formation can be maintained.

According to the present invention, an outstanding effect can be obtained such that production of particles in the vaporizer can be reduced and discharge of particles from the vaporizer can be reduced without sacrificing the maintainability of the apparatus or complicating control work for the apparatus.

Brief Description of Drawings

FIG. 1 is schematic sectional view showing a vaporizer of a prior art apparatus;

FIG. 2 is a block diagram showing an outline of a film forming apparatus according to an embodiment of the present invention;

FIG. 3A is a sectional view typically showing the movement of fluids (liquid source material and carrier gas) in a vaporizer during steady-state operation;

FIG. 3B is a sectional view typically showing the movement of fluids (liquid source material and carrier gas) in a vaporizer during steady-state operation;

FIG. 4 is a sectional view showing a film forming chamber of the film forming apparatus of the invention;

FIG. 5 is a characteristic diagram showing the formed of particles detected as the flow rate of the carrier gas is changed variously;

FIG. 6 is a characteristic diagram showing the dependence of the number of detected particles on the carrier gas flow rate;

FIG. 7 is a sectional view showing a vaporizer according to another embodiment;

FIG. 8 is a sectional view showing a vaporizer according to still another embodiment;

FIG. 9A is a flow distribution diagram showing flow velocities and directions of a fluid in various parts of a vaporization chamber of the apparatus of the embodiment;

FIG. 9B is a flow distribution diagram showing flow velocities and directions of a fluid in various parts of a vaporization chamber of an apparatus according to a comparative example;

FIG. 10 is a characteristic diagram showing the relation between the flow velocities (m/s) of the fluid in the center portion of the vaporization chamber of each of the apparatuses of the embodiment and the comparative example and the distance (m) from a nozzle;

FIG. 11A is a temperature distribution diagram showing temperatures in various parts of the vaporization chamber of the apparatus of the embodiment;

FIG. 11B is a temperature distribution diagram showing temperatures in various parts of the vaporization chamber of the apparatus of the comparative example; and

FIG. 12 is a characteristic diagram showing the relation between the temperature in the center portion of the vaporization chamber of each of the apparatuses of the embodiment and the comparative example and the distance from the nozzle.

Best Mode for Carrying Out the Invention

Various embodiments of the present invention will now be described with reference to the accompanying drawings.

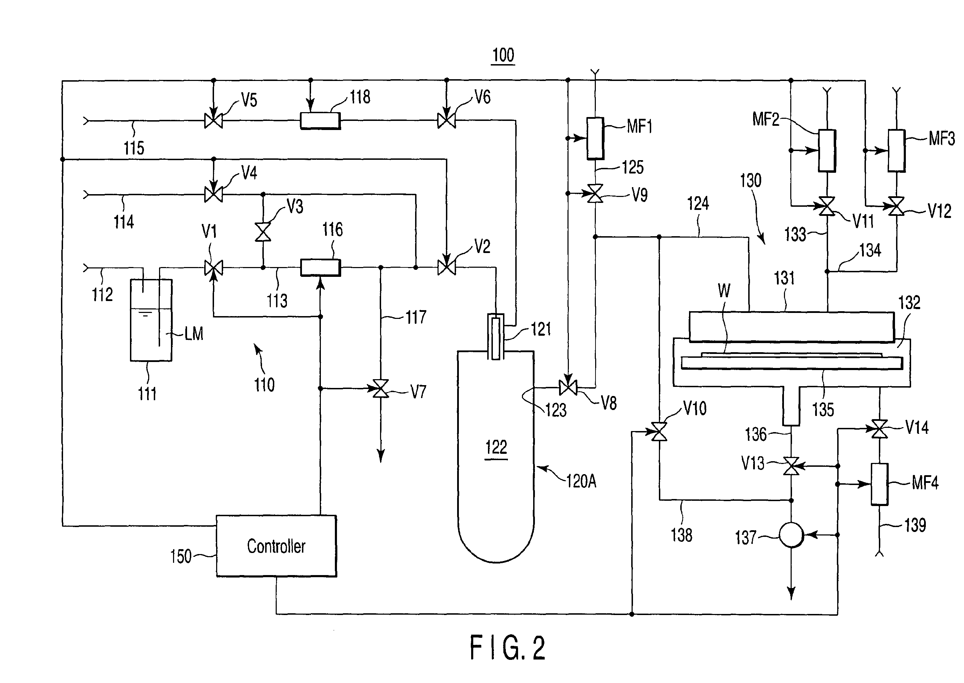

As shown in FIG. 2, a film forming apparatus 100 comprises a source material supply section 110, vaporizer 120A, film forming section 130, valves V1 to V14, mass flow controllers 116 and 118 and MF1 to MF4, and controller 150. The vaporizer 120A includes a spray nozzle 121 and a vaporization chamber 122. The controller 150 generally controls the film forming apparatus 100 as a whole.

The source material supply section 110 is provided with a source material container 111, which stores a liquid source material LM. The container 111 is connected with a compressed gas supply pipe 112 and a source material supply pipe 113. A compressed gas (e.g., inert gas such as He, $N_2$, Ar, etc.) for forcing out the source material LM in the container 111 is supplied through the pipe 112. The source material LM is supplied from the container 111 to the vaporizer 120A through the pipe 113. Further, the source material supply section 110 includes an inert gas supply pipe 114 and a carrier gas supply pipe 115. An inert gas, such as $N_2$, He or Ar, is supplied through the pipe 114. A carrier gas that is formed of the inert gas is supplied through the pipe 115.

The source material supply pipe 113 is connected with a flow controller 116, such as a liquid mass flow meter. Further, a drain pipe 117 is connected to that part of the pipe 113 which is located in a downstream position with respect to the controller 116. The inert gas supply pipe 114 is connected to suitable parts of the source material supply pipe 113. Furthermore, the carrier gas supply pipe 115 is connected with a flow controller 118, such as a mass flow meter.

The liquid source material LM may be any material that is prepared by diluting and dissolving a normally liquid or solid source material with an organic solvent, such as octane. Examples of the source material include hafnium tetra-tertiary butoxide [Hf(Ot-Bu)$_4$], tetra-diethylamino-hafnium [Hf(NEt$_2$)$_4$], tetrakis-methoxy-methyl-propoxy-hafnium [Hf(MMP)$_4$], tetra-dimethylamino-hafnium [Hf(NMe$_2$)$_4$], tetra-methylethylamino-hafnium [Hf(NMeEt)$_4$], pentaethoxy tantalum [Ta(OEt)$_5$], zirconium tetra-tertiary butoxide [Zr(Ot-Bu)$_4$], silicon tetraethoxide [Si(OEt)$_4$], tetra-dimethylamino-silicon [Si(NMe$_2$)$_4$], tetrakis-triethyl-siloxy-hafnium [Hf(OSiEt$_3$)$_4$], tetrakis-methoxy-methyl-propoxy-zirconium [Zr(MMP)$_4$], dis-

ethyl-cyclopentadiene-ruthenium [Ru(EtCp)$_2$], tertial amyl-imide-tridimethylamide tantalum [Ta(Nt-Am)(NMe$_2$)$_3$], tris-dimethylamino-silane [HSi(NMe$_2$)$_3$], etc. These materials may be also used without being diluted.

The vaporizer 120A includes the spray nozzle 121, the vaporization chamber 122, an outlet port 123, and heaters 126 and 127. The spray nozzle 121 communicates with the source material supply pipe 113 and the carrier gas supply pipe 115 that are provided with the mass flow controllers 116 and 118, respectively.

The vaporization chamber 122 has an elongated form extending in a Z-direction. The spray nozzle 121 opens in one end portion of the chamber 122, the other end portion of which is closed. The outlet port 123 opens in that part of a side peripheral wall of the vaporization chamber 122 which is located near the nozzle 121. Further, the outlet port 123 communicates with a source material gas supply pipe 124 that is connected to the film forming section 130. An additional carrier gas supply pipe 125 joins the supply pipe 124 through a valve V9.

The film forming section 130 serves to form a desired thin film on a wafer W with use of a source material gas that is supplied from the vaporizer 120A through the source material supply pipe 124. The film forming section 130 includes a gas inlet portion 131 having a showerhead structure and a film forming chamber 132. The source material gas and a reactive gas are supplied to the chamber 132 through the gas inlet portion 131. The gas inlet portion 131 is connected with a reactive gas supply pipe 133 through which the reactive gas is supplied. An inert gas supply pipe 134 is connected to the middle of the reactive gas supply pipe. The film forming chamber 132 is defined by a closed chamber and has therein a susceptor 135 in which a heater element is embedded. A substrate W, such as a silicon substrate, is placed on the susceptor 135. The substrate W is heated by the heater element. The chamber 132 is connected with an exhaust pipe 136, which is connected to an exhaust system, such as a vacuum pump 137. A bypass pipe 138 is connected to the middle of the source material supply pipe 124. It is also connected to that part of the exhaust pipe 136 which is located in an upstream position with respect to the pump 137. Further, the film forming chamber 132 is connected with a purge supply pipe 139 through which a purge gas is supplied. The purge gas prevents the film forming material from being deposited on a wall surface of the closed chamber or the like.

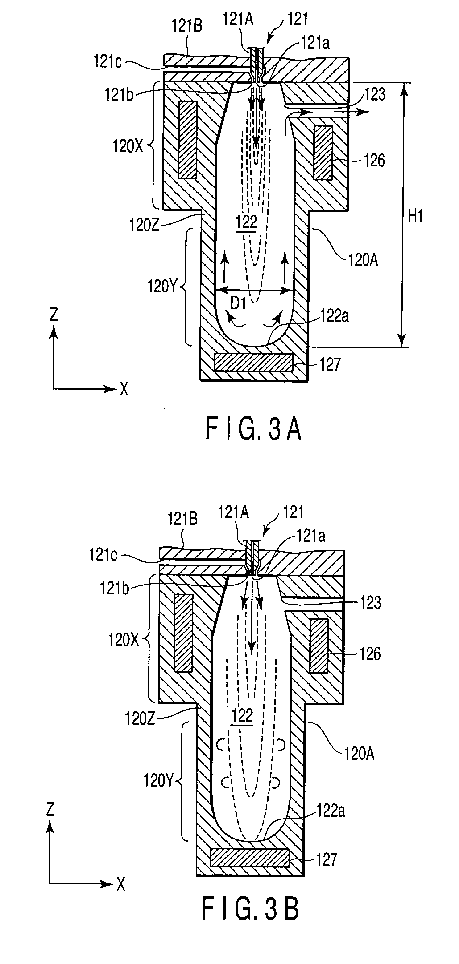

FIG. 3A is a schematic sectional view more specifically showing the construction of the vaporizer 120A. The spray nozzle 121 of the vaporizer 120A has a source material jet 121a and a gas jet 121b, which are connected to the source material supply pipe 113 and the carrier gas supply pipe 115, respectively. The liquid source material LM and the carrier gas are ejected through the jets 121a and 121b, respectively. The gas jet 121b has an annular form adjoining the periphery of the source material jet 121a. The caliber of the source material jet 121a ranges from about 0.05 to 0.3 mm, and preferably from about 0.1 to 0.15 mm. The cross section of the opening of the gas jet 121b is adjusted to about 1 to 20 times as large as that of the source material jet 121a, and preferably to about 1 to 12 times.

The source material jet 121a is formed of a distal opening of a source material jet pipe 121A. The jet pipe 121A is formed of a polyimide resin or some other synthetic resin that is resistant to an organic solvent. Alternatively, the pipe 121A may be formed of a metal material, such as stainless steel or titanium (Ti). If the jet pipe 121A is formed of a synthetic resin, the liquid source material LM cannot be easily heated by heat that is transferred from the surroundings before it is sprayed. If a polyimide resin is used, moreover, the residue (deposit) of the liquid material cannot easily adhere to the pipe, so that the possibility of clogging is lowered.

A nozzle block 121B is provided with a carrier gas inlet line 121c. The distal end portion of the source material jet pipe 121A is introduced into an opening portion of the inlet line 121c, and the gas jet 121b is located around the distal end of the jet pipe 121A. The source material and gas jets 121a and 121b open in the same direction (Z-direction). Thus, the ejection direction of the liquid source material LM is substantially the same as that of the carrier gas.

In this embodiment, only the liquid source material LM is ejected through the source material jet 121a, while only the carrier gas is ejected through the gas jet 121b. If the source material is introduced into the nozzle in a gas-liquid mixture state when it is ejected through the nozzle portion 12a, as in the case of the conventional construction shown in FIG. 1, for example, impurities in the liquid source material and the carrier gas may react and deposit in the nozzle, or solid matters deposited at the apex portion of the internal block 13 may clog the nozzle, in some cases. In the present embodiment, on the other hand, only the liquid source material is ejected through the source material jet 121a, so that solid matters can be prevented from being deposited in or near the nozzle.

Further, both the liquid source material LM and the carrier gas are injected substantially in the same direction into the vaporization chamber 122. Accordingly, a mist that is sprayed through the spray nozzle 121 advances within a relatively small angular range into the chamber 122. Thereupon, the mist is restrained from scattering in the nozzle-side portion of the chamber 122, that is, inside a proximal-end-side portion 120X. Accordingly, the mist can neither be discharged directly through the outlet port 123 (mentioned later) nor be solidified by being directly touching the inner surface of the chamber 122. Thus, particles can be prevented from being produced and discharged through the outlet port 123.

The closed other end 122a of the vaporization chamber 122 is kept at a long enough distance from the spray nozzle 121 to allow the liquid source material injected through the spray nozzle 121 to vaporize. More specifically, the chamber 122 has a shape such that its spray-direction length (or longitudinal length) H1 is greater than its width (or diameter) D1 in a direction (X- or Y-direction) perpendicular to the spray direction (Z-direction). If the liquid source material LM and the carrier gas are sprayed through the spray nozzle 121, therefore, a mist of the material LM is produced and advances toward a distal-end-side portion 120Y of the vaporization chamber 122 on the side opposite from the spray nozzle. As this is done, however, it is hard for the mist directly to reach the inner surface portion 122a of the chamber 122 that is opposed to the spray nozzle 121. Having this extended shape, the chamber 122 can be set so that the mist of the liquid source material LM that advances in the extension direction of the chamber 122 is subjected to radiant heat from the inner surface of the chamber 122 and heat conduction as it flies. Thus, vaporization of the mist can be nearly finished by the time the mist reaches the inner surface of the vaporization chamber 122.

Preferably, the longitudinal length H1 of the vaporization chamber 122 should be set so that the source material mist that is sprayed through the spray nozzle 121 never reaches that inner surface portion of the chamber 122 which faces the spray direction. This condition is set depending on the longitudinal length H1, cross-sectional area, and temperature distribution of the chamber 122, the amount of mist sprayed through the nozzle 121, the diameter of mist particles, the carrier gas amount, etc. Thus, production of particles can be prevented more securely.

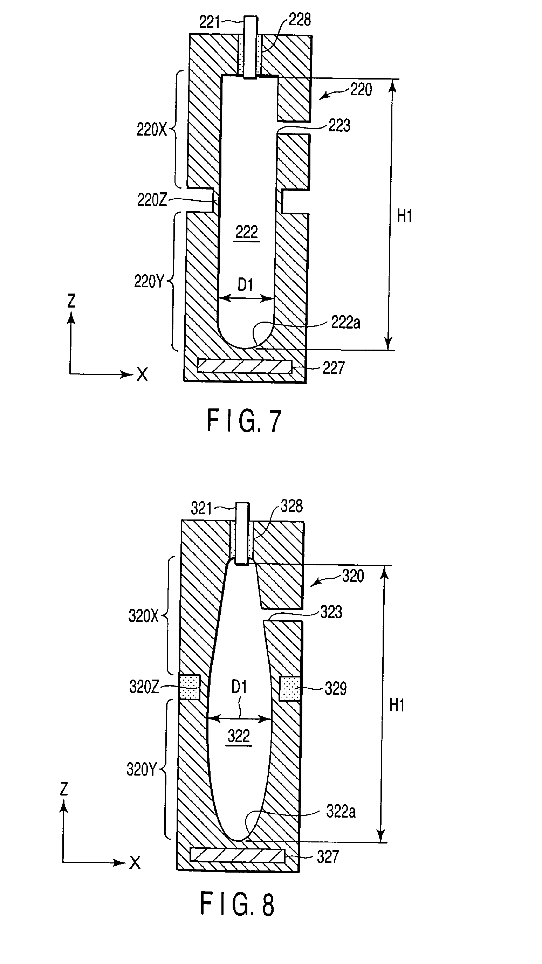

In the present embodiment, the ratio (HI/D1) between the longitudinal length H1 and the diameter D1 of the vaporization chamber 122 should preferably be adjusted to 2.5 or more, and more preferably to 3.5 or more. The longitudinal direction of the vaporization chamber 122 is in line with the source material spray direction (Z-direction). Further, the diameter D1 of the chamber 122 is supposed to be an average diameter (FIGS. 3A, 3B and 7) or a maximum diameter (FIG. 8) of its cross section perpendicular to the spray direction (Z-direction).

In the vaporization chamber 122 of the present embodiment, the ratio (H1/D1) is set within the range of 3.0 to 5.0. If the ratio (H1/D1) is lower than 2.0, the rate of particle production in the film forming chamber 132 increases. If the ratio (H1/D1) exceeds 6.0, on the other hand, the source material mist easily adheres to the side peripheral wall of the vaporization chamber 122 and directly gets into the outlet port 123 through the spray nozzle 121, so that the particle production rate may possibly rather increase. Preferably, moreover, the cross-sectional shape of the chamber 122 should be truly or equivalently circular. In the vaporization chamber 122 of this shape, the mist is isotropically influenced by heat from the inner peripheral wall surface of the chamber 122, so that a more stable vaporized state can be obtained.

The inner wall surface of the vaporization chamber 122 is heated by heater elements 126 and 127, each of which is formed of a heater of the resistance-heating type, e.g., a cartridge heater (embedded type) or tape heater (wound type). In general, the heating temperature of these heaters should preferably be set at a temperature higher than the vaporization temperature of the liquid source material LM and lower than the decomposition temperature of the material LM. This is because the source material LM decomposes and solidifies at the decomposition temperature or higher. The first heater element 126 is located in the proximal-end-side portion 120X on the side nearer to the spray nozzle 121 than the longitudinally middle position of the vaporization chamber 122. The second heater element 127 is located in the distal-end-side portion 120Y on the opposite side of the longitudinally middle position of the chamber 122 from the nozzle 121. The second heater element, in particular, is embedded in a peripheral wall near the closed other end portion 122a of the chamber 122.

Further, an intermediate portion 120Z between the proximal-end-side portion 120X and the distal-end-side portion 120Y has a cross section that is much smaller than that of the proximal-end-side portion 120X. The intermediate portion 120Z is equivalent to a junction that removably connects the proximal-end-side portion 120X and the distal-end-side portion 120Y. In the illustrated example, the cross section of the intermediate portion 120Z is about 1/10 of that of the proximal-end-side portion 120X. Thus, heat conduction between the portions 120X and 120Y can be restrained, so that the respective temperatures of these two portions can be set more accurately.

The vaporization chamber 122 is constructed so that the inner surface temperature of the proximal-end-side portion 120X is higher than that of the distal-end-side portion 120Y. Since the quantity of heat transferred to the spray nozzle 121 can be reduced by lowering the inner surface temperature of the proximal-end-side portion 120X, the liquid source material LM can be prevented from being heated to boil in the nozzle 121 and from varying in the rate of spray. By raising the inner surface temperature of the distal-end-side portion 120Y, moreover, the convecting mist can be fully heated so that almost all the mist that is sprayed through the spray nozzle 121 can be vaporized before it touches the inner surface of the portion 120Y.

The difference in temperature between the proximal-end-side portion 120X and the distal-end-side portion 120Y should preferably range from 20 to 70°C, and more preferably from 30 to 60°C. If the range of the temperature difference is narrower, the aforesaid effect cannot be obtained satisfactorily. If the range is wider, deposits are easily produced on the proximal-end-side portion 120X and the intermediate portion 120Z. In forming a thin film of hafnium oxide $[HfO_2]$, for example, hafnium tetra-tertiary butoxide $[Hf(Ot-Bu)_4]$ (hereinafter referred to as HTB) dissolved in octane is used as the liquid source material LM, and oxygen as a reactive gas is caused to react with the source material gas that is obtained by vaporizing the liquid material LM. The inner surface temperature of the proximal-end-side portion 120X ranges from 90 to 110°C, and preferably from 95 to 105°C, while that of the distal-end-side portion 120Y ranges from 120 to 170°C, and preferably from 155 to 165°C. These temperature conditions depend on the components of the source material. If any other source material is used, the temperature ranges differ from the aforesaid ones.

In the present embodiment, the vaporization chamber 122 has the elongated form extending in the Z-direction, so that the distance of flight of the source material mist in the chamber 122 is long. Therefore, the mist can be fully vaporized by heating while it is flying. Since most of the source material mist finishes vaporization before it reaches the inner wall surface of the vaporization chamber 122, the vaporization efficiency is improved, and the particle production rate is lowered considerably.

Dotted lines in the vaporization chamber 122 shown in FIG. 3A typically indicate the distribution of the source material mist sprayed through the spray nozzle 121. The sprayed liquid source material is reduced by the carrier gas to a fine mist in a position distant from the spray nozzle 121, and is distributed in the manner indicated by the dotted lines. As the source material mist advances in the longitudinal direction of the vaporization chamber 122, it is heated and vaporized by radiant heat from the inner wall surface of the chamber 122. Thereupon, almost all the source material mist is vaporized into a source material gas near the closed other end portion 122a. The generated source material gas returns along the inner peripheral side face of the vaporization chamber 122, as indicated by arrows in FIG. 3A, and finally gets out of the chamber 122 through the outlet port 123.

In FIG. 3B, dotted lines indicate a state in which the flow rate of the liquid source material LM or the carrier gas ejected through the spray nozzle 121 is increased in the vaporizer 120A. In this case, some of the source material mist intensively collides against the center portion of the inner surface portion 122a. In consequence, there is a possibility of solid matter deposition on the inner surface portion 122a or of some of the mist being suddenly heated and decomposed. In this case, the rate of particle production in the vaporization chamber 122 increases, so that the amount of particles discharged through the outlet port 123 is supposed also to increase. Since the rate of spray through the nozzle 121 increases, moreover, the source material gas generated inside the distal-end-side portion 120Y is prevented by the spray gas from easily returning toward the outlet port 123. Accordingly, a turbulent flow is easily generated in the vaporization chamber 122, so that particles produced in the chamber 122 may possibly be discharged through the outlet port 123 with ease.

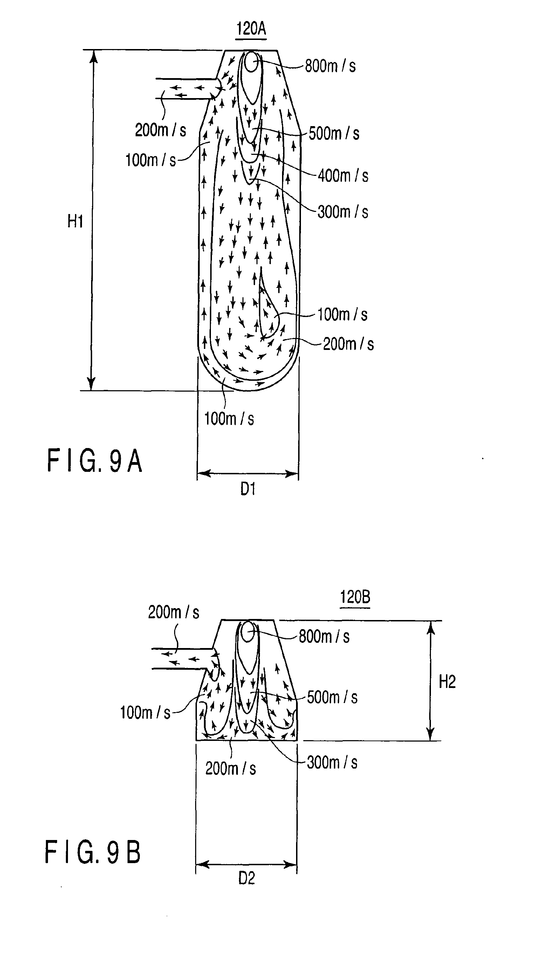

With the vaporizer 120A of the present embodiment, nitrogen gas ($N_2$) fed through the spray nozzle 121 into the vaporization chamber 122 was adjusted to 1,500 sccm, and the pressure of a pipe connected to the outlet port was kept at 1.93 kPa. In this state, the flow velocity and temperature distribution in the vaporization chamber 122 were measured. Further, a conventional vaporizer 120B of which the vaporization chamber has a spray-direction length of about 22 mm was given as a comparative example, and the flow velocity and temperature distribution in the vaporization chamber were measured under the same conditions for the foregoing embodiment. FIGS. 9A, 9B, 10, 11A, 11B and 12 individually show results of these measurements.

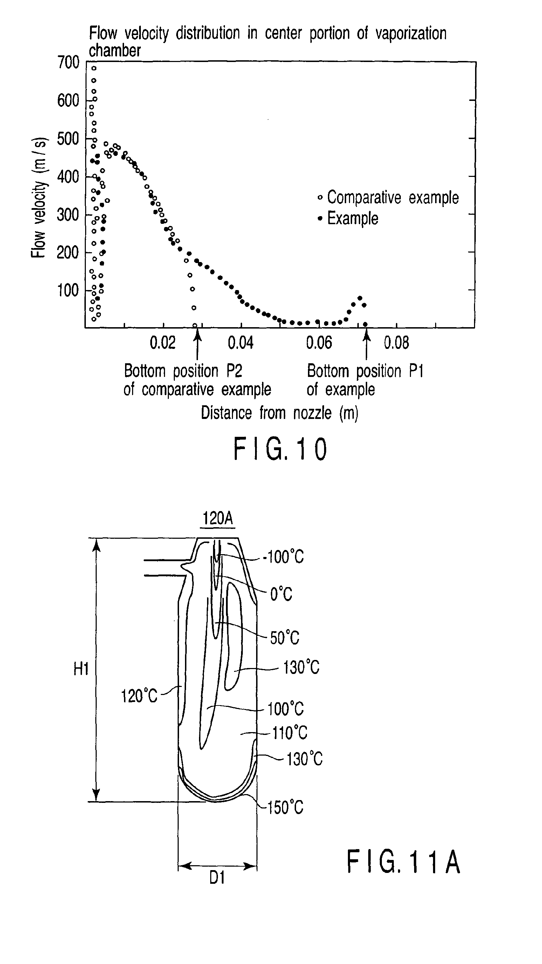

FIG. 9A shows a result (experimental data) of an examination on flow velocity and directions of a fluid in the vaporization chamber of the vaporizer 120A of the embodiment. FIG. 9B shows a result (experimental data) of an examination on flow velocity and directions of a fluid in the vaporization chamber of the vaporizer 120B of the comparative example. Further, FIG. 10 shows a result (experimental data) of an examination on the relation between the flow velocity of the fluid in the center portion of the vaporization chamber and the distance from the nozzle.

As seen from FIGS. 9A, 9B and 10, the flow velocity changes drastically at one end portion (nozzle side) of the vaporization chamber in the vaporizer 120A of the embodiment, while it changes slowly at the closed other end portion of the vaporization chamber. Thus, the flow velocity and the flow direction are smoothly distributed on the inner surface portion 122a at the bottom. Since the flow velocity of the mist is low enough on the inner surface portion 122a, moreover, there is a certain allowance of time before the source material mist reaches the inner surface portion 122a. Since a fluid current smoothly flows along the inner surface portion 122a at the bottom, moreover, it can be supposed to be difficult for the source material mist reach the inner surface portion 122a.

In the vaporizer 120B of the comparative example, on the other hand, a flow of the source material sprayed through the nozzle collides against the inner wall surface of the closed other end portion (bottom portion) at high speed, and the flow velocity and direction of the fluid were disturbed on the inner wall surface of the bottom portion.

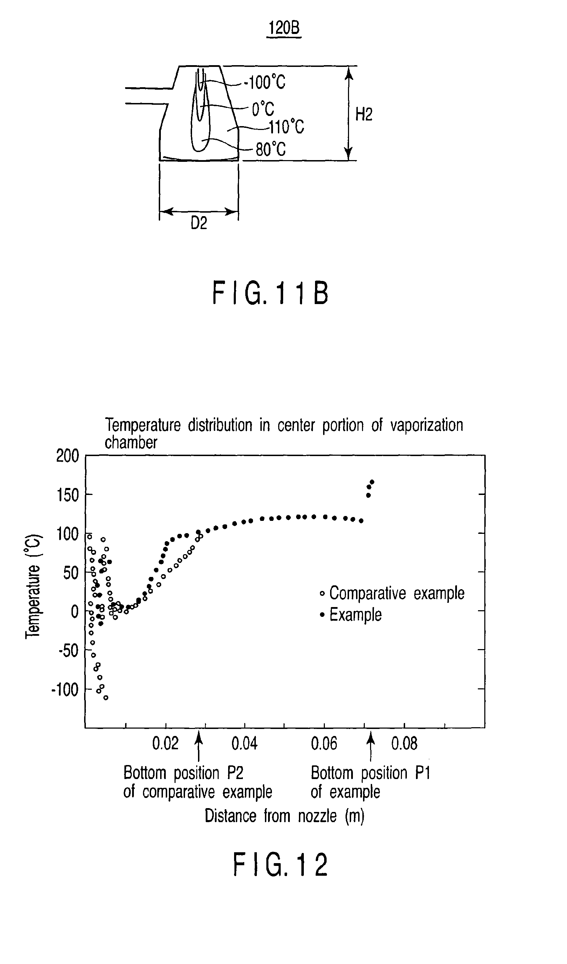

FIG. 11A shows a result (experimental data) of an examination on the temperature distribution in the vaporization chamber of the vaporizer 120A of the embodiment. FIG. 11B shows a result (experimental data) of an examination on the temperature distribution in the vaporization chamber of the vaporizer 120B of the comparative example. Further, FIG. 12 shows a result (experimental data) of an examination on the relation between the temperature in the center portion of the vaporization chamber and the distance from the nozzle.

As seen from FIGS. 11A, 11B and 12, a flow from the spray nozzle of the vaporizer 120A of the embodiment is fully heated to high temperature (100°C or more) as it advances in the Z-direction. The temperature of the flow is substantially equal to the ambient temperature and its change is slow when the flow reaches the inner wall surface of the closed other end portion (bottom portion).

On the other hand, a flow from the spray nozzle of the vaporizer 120B of the comparative example can be heated only to an unsatisfactory temperature (80°C or thereabout) as it advances in the spray direction, and reaches the inner wall surface of the closed other end portion (bottom portion) in the course of temperature rise.

According to the experimental results described above, the mist sprayed through the spray nozzle of the comparative example is blown directly against the inner surface of the vaporization chamber that faces the nozzle,

EP 1 724 817 A1

whereby the temperature of the inner surface may be lowered, in some cases. On the other hand, the mist sprayed through the spray nozzle of the embodiment is fully heated as it advances in the spray direction. It is evident, therefore, that much of the mist is vaporized before it reaches the inner surface of the vaporization chamber, and that the remaining mist is also blown against the inner surface of the vaporization chamber that faces the spray nozzle in a manner such that the vaporization temperature is fully reached by the temperature of the inner surface. According to the comparative example, therefore, the unvaporized mist directly reaches the inner surface of the vaporization chamber so that only the solvent vaporizes. Thus, the source material may possibly solidify and form a source of particles. According to the embodiment, on the other hand, the mist is mostly vaporized before it reaches the inner surface. Even if the remaining mist succeeds in reaching the inner surface of the vaporization chamber, moreover, it is fully heated and vaporized on the inner surface. In consequence, the mist hardly solidifies on the inner surface of the vaporization chamber, and production of particles can be restrained.

According to the present embodiment, moreover, the cross section of the intermediate portion 120Z is so small that the quantity of heat transferred from the distal-end-side portion 120Y at high temperature to the proximal-end-side portion 120X at low temperature is reduced. Accordingly, the temperature-controllability of the portions 120X and 120Y is improved, and a substantial temperature difference can be easily set between the two portions. Thus, the temperature rise of the spray nozzle 121 can be further reduced.

The outlet port 123 opens in the side face portion of the vaporization chamber 122 corresponding to the proximal-end-side portion 120X. Thus, the possibility of the mist directly heading toward the outlet port 123 can be lowered, and the mist generated in the chamber 122 can be restrained from being discharged through the outlet port 123. More specifically, in the illustrated example, the inner wall surface of the vaporization chamber 122 at the proximal-end-side portion 120X is tapered so that the inside diameter of the chamber gradually increases in the spray direction, and the outlet port 123 opens in the tapered inner wall surface. Thus, the source material mist can be prevented more securely from heading from the spray nozzle 121 directly toward the outlet port 123.

The inner surface portion 122a (i.e., inner wall surface of the bottom portion) of the closed other end portion of the vaporization chamber 122 is concaved. Preferably, the concave surface is in the shape of a rotating body that is formed by rotating a concave line around the spray nozzle 121. Although the inner surface portion 122a is hemispherical in the illustrated example, it may alternatively be paraboloidal, ellipsoidal, or hyperboloidal. Thus, the distribution of the tip portion of the spread of the source material sprayed through the nozzle 121 corresponds in shape to the inner surface portion 122a at the bottom. Accordingly, the mist can be heated more uniformly than in the case where the inner bottom wall surface is flat. Further, the mist can be prevented from intensively colliding against part of the inner surface portion 122a to deposit a precipitate on the inner surface.

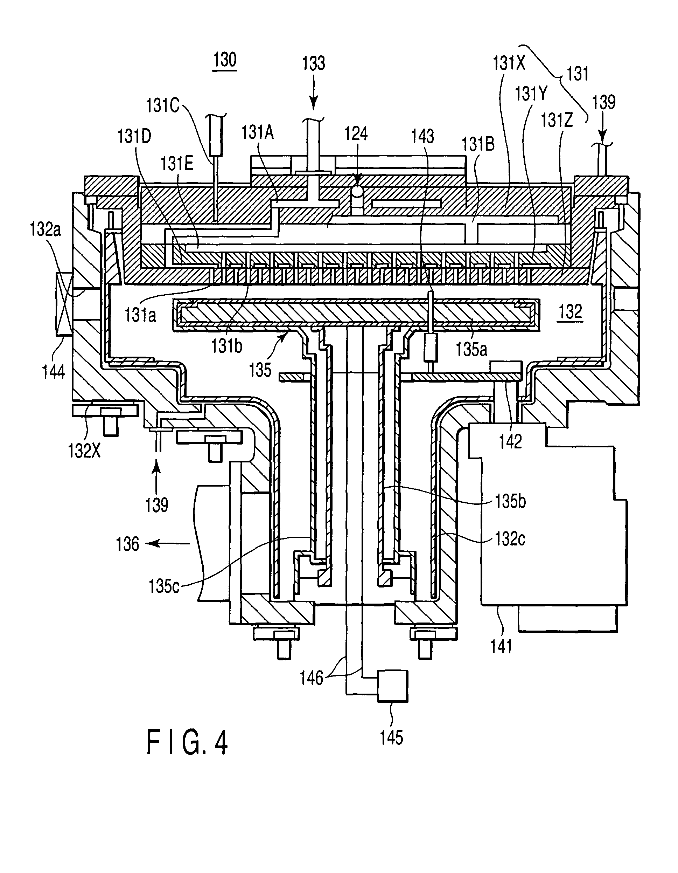

FIG. 4 is a detailed sectional view showing a principal part of the film forming section 130. The gas inlet portion 131 for use as a showerhead is located in the upper part of the film forming section. The gas inlet portion 131 includes an upper plate 131X, middle plate 131Y, and lower plate 131Z that are stacked in layers. The gas inlet portion 131 is provided with a source material passage 131A that is connected to the source material supply pipe 124. The passage 131A diverges into a large number of branches via a diffusion space 131D. The respective distal ends of these branches individually form a large number of source material gas supply ports 131a that are arranged dispersedly on the inner surface of the gas inlet portion 131. Further, the reactive gas supply pipe 133 is connected with a reactive gas passage 131B, which diverges into a large number of branches via a diffusion space 131E. The respective distal ends of these branches individually form a large number of reactive gas supply ports 131b that are arranged dispersedly on the inner surface of the gas inlet portion 131. Thus, the gas inlet portion 131 has a post-mix showerhead structure into which the source material gas and the reactive gas are introduced separately. The gas inlet portion 131 is furnished with a temperature sensor 131C.

The film forming chamber 132 is a sealable space that is defined by the gas inlet portion 131 and a film forming vessel 132X. The vessel 132X is provided with an inlet port 132a that can be opened or closed by a gate 144. The substrate can be carried in or out when the gate 144 is opened. The inner wall of the chamber 132 is covered by a deposit shield 132c that is formed of quartz or the like. A purge gas (inert gas such as $N_2$) that is supplied through the purge supply pipe 139 is run between the shield 132c and the inner surface of the vessel 132X lest any deposit adhere to the inner surface of the vessel 132X.

The susceptor 135 that has a substrate supporting surface (upper surface as illustrated) formed of SiC or the like is disposed in the film forming chamber 132. A heater 135a, such as a resistance-heating element, is incorporated in the susceptor 135. The heater 135a is connected to a heater power source 145 by a wire 146. The susceptor 135 has a support portion 135b, which is fixed to the film forming vessel 132X. The whole surface of the susceptor 135, including the substrate supporting surface, is covered by a deposit shield 135c that is formed of quartz or the like. The susceptor 135 is fitted with a plurality of lifter pins 143 (only one of which is shown in FIG. 4 with others omitted) that can project and retract from the substrate supporting surface. The lifter pins 143 are supported on a pin support portion 142. They move up and down as the support portion 142 is driven by a drive unit 141. An opening portion at the lower part of the film forming vessel 132X is connected to the exhaust pipe 136, and the film forming chamber 132 is uniformly exhausted by the vacuum pump.

In the film forming chamber 132, the following thin films can be formed on substrates by using the various liquid source materials described above. Dielectric thin films to be formed include, for example:

$HfO_2$:

Source material gas = $Hf(Ot-Bu)_4$, reactive gas = $O_2$,
Source material gas = $Hf(NEt_2)_4$, reactive gas = $O_2$ or $O_3$,
Source material gas = $Hf(MMP)_4$, reactive gas = $O_2$,
Source material gas = $Hf(NMe_2)_4$, reactive gas = $O_2$,
Source material gas = $Hf(NMeEt)_4$, reactive gas = $O_2$;

$Ta_2O_5$:

Source material gas = $Ta(OEt)_5$, reactive gas = $O_2$;

HfSiOx (x is natural number):

Source material gas = $Hf(OSiEt_3)_4$, reactive gas = $O_2$;

$ZrO_2$:

Source material gas = $Zr(Ot-Bu)_4$, reactive gas = $O_2$,
Source material gas = $Zr(MMP)_4$, reactive gas = $O_2$;

$SiO_2$:

Source material gas = $Si(OEt)_4$, reactive gas = $O_3$,
Source material gas = $Si(NMe_2)_4$, reactive gas = $O_2$,
Source material gas = $HSi(NMe_2)_3$, reactive gas = $O_2$;

$(HfO_2)_x(SiO_2)_y$ (x and y are natural numbers):

Source material gas = $Hf(NEt_2)_4 + Si(NMe_2)_4$, reactive gas = $O_2$,

Source material gas = $Hf(Ot-Bu)_4 + SiH_4$, reactive gas = $O_2$,

Source material gas = $Hf(Ot-Bu)_4 + Si(OEt)_4$, reactive gas = $O_2$.

$$\text{Source material gas} = Hf(Ot\text{-}Bu)_4 + Si(OEt)_4,$$

$$\text{reactive}$$

$$\text{gas} = O_2.$$

Further, thin metal films include:

$Ru/RuO_2$:

Source material gas = $Ru(EtCp)_2$, reactive gas = $O_2$;

TaN:

$$\text{Source material gas} = Ta(Nt\text{-}Am)(NMe_2)_3, \text{ reactive}$$

$$\text{gas}$$

$$= NH_3.$$

In the above chemical formulas, Me is a methyl group ($CH_3$), Et is an ethyl group ($C_2H_5$), Bu is a butyl group ($C_4Hg$), Cp is a cyclopentadiene group, Am is an amyl group ($C_5H_{11}$), MMP is a methoxypropoxy group. Further, a material that is obtained by dilution to, e.g., 0.2 mol/l with an organic solvent, such as octane, may be used as an original source material of each source material gas.

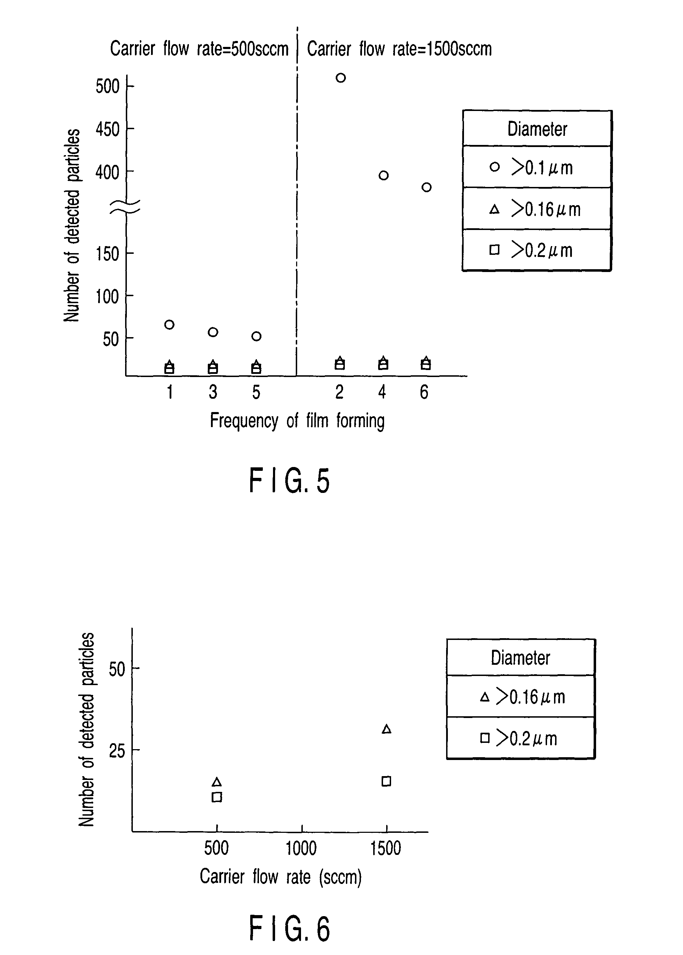

FIG. 5 shows a result of measurement of the number of particles appearing on a 300-mm wafer in the center portion of a substrate set in the film forming chamber 132 with the carrier gas flow rate varied. Let it now be supposed that the film forming temperature is 550°C, the pressure in the film forming chamber 132 is about 40 Pa (0.3 Torr), the film forming time is 120 seconds, the feed rate of the HTB (0.2 Torr sccm mg/l) used as the liquid source material is 45 mg/min, the flow rates of $N_2$ used as the carrier gas in the vaporizer 120 is 1,500 sccm and 500 sccm, the flow rate of $O_2$ used as the reactive gas is 100 sccm. In FIGS. 5 and 6, circles, triangles, and squares represent the numbers of particles that have diameters of 0.1 $\mu$m or more, 0.16 $\mu$m or more, and 0.2 $\mu$m or more, respectively.

If the carrier gas flow rate is 500 sccm, compared with 1,500 sccm, as shown in FIG. 5, the number of particles that have diameters of 0.1 $\mu$m or more is considerably reduced to about 1/10. This tendency also applies to the number of particles that have diameters of 0.16 $\mu$m or more and the number of particles that have diameters of 0.2 $\mu$m or more.

As shown in FIG. 6, the number of particles increases with the increase of the carrier gas flow rate. If the carrier gas flow rate thus increases in the vaporizer 120A, the number of particles that are introduced into the film forming chamber 132 increases. It is indicated, in particular, that the number of fine particles of 0.1 to 0.15 $\mu$m is increased considerably. This is believed to occur because if the flow rate of the carrier gas increases, the range of flight of the mist sprayed through the spray nozzle 121 is enlarged, as shown in FIG. 3B. If this is done, a solid matter may be deposited on the inner surface of the vaporization chamber 122 or a large number of fine mists may be deposited. If only the solvent volatilizes from the fine mists, a solid matter can be deposited. Preferably, under these conditions, the flow rate of the carrier gas introduced into the vaporizer 120A should be restricted within the range of 30 to 600 sccm, and especially of 50 to 500 sccm, in order to restrain the number of particles.

Based on these results, the number of particles introduced into the film forming chamber 132 can be reduced by lowering the flow rate of the carrier gas that gets into the vaporization chamber 122. If the flow rate of the carrier gas introduced into the vaporization chamber 122 is lowered excessively, however, the source material gas distribution in the film forming chamber 132 becomes uneven, so that the within-wafer uniformity of the thickness of the thin film on the substrate may be degraded or the film quality may vary. These problems are attributable to the failure of a mixture of the source material gas and the carrier gas to be uniformly dispersed in the showerhead 131 because of the low flow rate of the mixed gas.

According to the present embodiment, therefore, the additional carrier gas supply pipe 125 (additional carrier gas inlet portion) is provided between the vaporizer 120A and the film forming chamber 132, as shown in FIG. More specifically, the supply pipe 125 is connected to a suitable portion of the source material supply pipe 124. The carrier gas can be additionally introduced into the pipe 124 through the pipe 125. Thus, even if the flow rate of the carrier gas from the vaporizer 120A is reduced, the partial pressure of the carrier gas that is supplied to the film forming chamber 132 can be increased. In consequence, the number of particles introduced into the chamber 132 can be reduced as the uniformity of the thin film formed on the substrate W is enhanced. Alternatively, the additional carrier gas supply pipe 125 may be provided in the gas inlet portion 131 of body of the film forming apparatus.

Using the apparatus described above, an experiment was conducted on the influence of the additional carrier gas supply on the quality level of the thin film formed on the wafer. Table 1 below shows results of the experiment. The source material gas used in this experiment was prepared by vaporizing HTB of 0.2 mol/l diluted with octane. The reactive gas was $O_2$, and the carrier gas and the additional carrier gas introduced into the vaporizer 120A were $N_2$. The wafer was a silicon substrate of 300-mm diameter, and the thickness of the formed thin film was measured by using an ellipsometer. The film thickness was measured at 49 points, which include a center point and none of which fall on a 3-mm wide peripheral edge portion of the wafer. Particles were measured in the same manner as aforesaid, and particles having diameters of 0.2 $\mu$m or more on the wafer were counted.

Table 1 shows conditions and results for Examples A and B and the comparative example together. In Example A, the flow rate of the carrier gas introduced into the vaporizer was high (2,200 sccm), and no additional carrier gas was supplied. In Example B, the flow rate of the carrier gas introduced into the vaporizer was lowered (40 sccm), and the additional carrier gas was supplied at a high flow rate (2,000 sccm). In the comparative example, the flow rate of the carrier gas introduced into the vaporizer was lowered (40 sccm), and no additional carrier gas was supplied.

In Example A, the uniformity of the thin film was good ($\sigma$ = 2.22%), although the number of particles introduced into the film forming chamber was large (115). In the comparative example, on the other hand, the uniformity of the thin film was degraded considerably ($\sigma$ = 34.66%), although the number of particles introduced into the film forming chamber was small (10). In Example B, the number of particles introduced into the film forming chamber was very small (10), and besides, the uniformity of the thin film was very good ($\sigma$ = 2.32%).

Table 1

| | | Example A | Comparative example | Example B |
|---|---|---|---|---|
| Flow rate of carrier (SCCM) | | 2200 | 40 | 40 |
| Flow rate of additional carrier (SCCM) | | non | non | 2000 |
| Deposition condition | Temperature (°C) | 550 | 550 | 550 |
| | Pressure (Pa) | 40 | 40 | 40 |
| | Deposition time (sec) | 120 | 120 | 120 |
| | Source material (mg/min) | 45 | 45 | 45 |
| | Oxygen (SCCM) | 100 | 560 | 560 |
| Thickness (nm) | Center portion | 2.603 | 3.128 | 2.458 |
| | Average | 2.588 | 3.224 | 2.403 |
| | Uniformity σ (%) | 2.22 | 34.66 | 2.32 |
| Number of particles (Diameter of more than 0.20 $\mu$m) | | 115 | 10 | 10 |

FIG. 7 is a schematic sectional view showing a vaporizer 220 according to another embodiment. The vaporizer 220 of the present embodiment comprises a spray nozzle 221, a vaporization chamber 222, and an outlet port 223. The spray nozzle 221 and the outlet port 223 are constructed substantially in the same manner as their counterparts according to the foregoing embodiment. As in the foregoing embodiment, moreover, a heater 227 is embedded in the peripheral wall of a bottom portion of the vaporizer 220, and another heater (not shown) in the peripheral wall of an upper part of the vaporizer.

The vaporizer 220 of the present embodiment differs from the vaporizer of the foregoing embodiment in that a heat insulator 228 is located between the spray nozzle 221 and its surrounding peripheral wall. The insulator 228 serves to restrain a temperature rise of the nozzle 221. Thus, a liquid source material can be prevented from boiling in the nozzle 221 and varying in the rate of spray, and solid matters can be prevented from being deposited in the nozzle 221 and clogging it. An incombustible material, such as asbestos, may be used for the heat insulator 228. The thickness of the insulator 228 may be adjusted to, for example, 7 to 18 mm.

Further, the heat insulator 228 may or may not be kept in contact with the outer periphery of the nozzle 221. Instead of the insulator 228, heat insulating air layer may be provided around the nozzle 221. The length of the nozzle 221 may be adjusted to, for example, 19.5 mm.

In the vaporizer 220, moreover, the vaporization chamber 222 is formed having a shape (e.g., cylindrical shape) such that it has a substantially uniform cross section throughout its body extending in the spray direction from the spray nozzle 221. However, an inner surface portion 222a that faces the nozzle 221 in the spray direction, like the one according to the foregoing embodiment, is concaved. Also in the vaporization chamber having this shape, which extends in the spray direction, as in the case of the foregoing embodiment, the outlet port opens in an inner side face of a proximal-end-side portion. Thus, the same effects of the foregoing embodiment can be obtained with use of this vaporization chamber shape.

In the vaporizer 220, furthermore, an intermediate portion 220Z is provided between a proximal-end-side portion 220X and a distal-end-side portion 220Y. The cross section (XY area) of the intermediate portion 220Z is smaller than the cross section (XY area) of either of the portions 220X and 220Y.

FIG. 8 is a schematic sectional view showing a vaporizer 320 according to still another embodiment. The vaporizer 320 of the present embodiment comprises a spray nozzle 321, a vaporization chamber 322, and an outlet port 323. The spray nozzle 321 and the outlet port 323 are constructed substantially in the same manner as their counterparts according to the foregoing embodiments. As in the foregoing embodiments, moreover, a heater 327 is embedded in the peripheral wall of a bottom portion of the vaporizer 320, and another heater (not shown) in the peripheral wall of an upper part of the vaporizer. The vaporizer 320 of the present embodiment has a nozzle heat insulator 328 similar to the nozzle heat insulator 228 of the vaporizer 220 of the foregoing embodiment.

At a proximal-end-side portion 320X, the cross section of the vaporization chamber 322 gradually increases with distance in the Z-direction from the spray nozzle 321, has its maximum value at a distal-end-side portion 320Y, and then gradually decreases. The same effects of foregoing embodiments can be obtained with use of this specially shaped vaporization chamber 322.

Further, the vaporizer 320 resembles the vaporizer 220 in that the intermediate portion 320Z with a reduced cross section is provided between the proximal-end-side portion 320X and the distal-end-side portion 320Y. However, the vaporizer 320 differs from the vaporizer 220 in that an insulator 329 is located between the proximal-end-side portion 320X and the distal-end-side portion 320Y, outside the intermediate portion 320Z. Alternatively, in this case, only the insulator 329 may be interposed between the portions 320X and 320Y without providing the intermediate portion 320Z between them.

The present invention is not limited to the embodiments described above, and various changes and modifications may be effected therein without departing from the scope or spirit of the invention. Although the source material gas used in each of the foregoing embodiments has been described as being of only one kind, for example, a plurality of kinds of source material gases may be used for the film formation instead. In this case, a plurality of source material supply systems may be provided so that a plurality of liquid source materials supplied from the supply systems can be mixed and fed into the vaporizer. Alternatively, a plurality of vaporizers may be provided so that each vaporizer can be used exclusively for each corresponding liquid source material. Although the apparatus according to each of the foregoing embodiments is constructed as an MOCVD apparatus, moreover, the invention may be also applied to various other film forming apparatuses, such as plasma CVD apparatuses, atomic layer deposition (ALD) apparatuses, LP-CVD apparatuses (batch type, vertical type, horizontal type, and mini-batch type), etc.

**Claims**

1. A film forming apparatus having a source material supply section which supplies a liquid source material, a vaporizer which vaporizes the liquid source material to generate a source material gas, and a film forming chamber into which the source material gas is introduced to form a thin film on a substrate to be processed,
the vaporizer **characterized by** comprising
a spray nozzle which spays the liquid source material supplied from the source material supply section,
a vaporization chamber which has one end portion in which the spray nozzle opens and a closed other end portion and in which the misty liquid source material sprayed through the spray nozzle is vaporized to generate the source material gas,
heating means which heats the vaporization chamber, and
an outlet port which opens in the vaporization chamber in the vicinity of the spray nozzle and through which the source material gas is discharged from the vaporization chamber,
the closed other end portion of the vaporization chamber being kept at a long enough distance from the spray nozzle to allow the liquid source material injected through the spray nozzle to vaporize.

2. An apparatus according to claim 1, wherein the heating means is located in a peripheral wall which defines the other end portion of the vaporization chamber and heats the other end portion of the vaporization chamber so that the temperature on the other end portion side of the vaporization chamber is higher than the temperature on the one end portion side.

3. An apparatus according to claim 1 or 2, which further comprises a heat transfer restricting structure which restricts heat transfer between the one end portion and the other end portion of the vaporization chamber.

4. An apparatus according to claim 1 or 2, wherein the outlet port is situated nearer to the spray nozzle than a middle position between the one end portion and the other end portion of the vaporization chamber and opens in a side peripheral wall of the vaporization chamber.

5. An apparatus according to claim 1 or 2, wherein the spray nozzle has a source material jet through which the liquid source material is ejected and an annular gas jet which is located adjacent to the periphery of the source material jet and through which a carrier gas is ejected, and the direction of ejection of the liquid source material through the source material jet is substantially the same as the direction of ejection of the carrier gas through the gas jet.

6. An apparatus according to claim 5, wherein only the liquid source material is ejected from the source material jet.

7. An apparatus according to claim 1 or 2, wherein the closed other end portion of the vaporization chamber is concaved.

8. An apparatus according to claim 1 or 2, which further comprises an additional carrier gas inlet portion through which a carrier gas is additionally supplied to a passage between the vaporizer and the film forming chamber.

9. An apparatus according to claim 1 or 2, wherein the ratio (H1/D1) between a longitudinal length H1 and a diameter D1 of the vaporization chamber ranges from 2.5 to 6.0.

10. An apparatus according to claim 9, wherein the ratio (H1/D1) ranges from 3.5 to 5.0.

11. An apparatus according to claim 9, wherein the length H1 is a length from a jet of the spray nozzle to a peripheral wall of the closed other end portion.

12. An apparatus according to claim 9, wherein the diameter D1 is a maximum inside diameter of the vaporization chamber.

13. An apparatus according to claim 9, wherein the diameter D1 is an average inside diameter from a middle position in the vaporization chamber to the other end portion.

14. An apparatus according to claim 9, wherein the inside diameter of the vaporization chamber gradually increases with distance from the spray nozzle at the one end portion side of the vaporization chamber, and the inside diameter of that part of the vaporization chamber which extends from the outlet port to the other end portion is substantially uniform, the substantially uniform inside diameter being equivalent to the inside diameter D1.

15. An apparatus according to claim 9, wherein the inside diameter of the vaporization chamber gradually increases with distance from the spray nozzle at the one end portion side of the vaporization chamber, the inside diameter has a maximum value in a middle position in the vaporization chamber, and the inside diameter of that part which extends from the middle position to the other end portion gradually degreases, the maximum inside diameter in the middle position being equivalent to the inside diameter D1.

16. An apparatus according to claim 9, wherein the inside diameter of that part of the vaporization chamber which extends from the one end portion to the other end portion thereof is substantially uniform, the substantially uniform inside diameter being equivalent to the inside diameter D1.

17. An apparatus according to claim 1 or 2, wherein the spray nozzle is embedded in a peripheral wall of the vaporization chamber on the one end portion side thereof, and which further comprises a heat insulating member which thermally insulates the spray nozzle from the peripheral wall.

10

11v — 11

11b —

12a —

12 — 14

13 —

12b — 12c

15

# FIG.1 PRIOR ART

FIG. 2

FIG. 3A

FIG. 3B

FIG. 4

Carrier flow rate=500sccm | Carrier flow rate=1500sccm

| Diameter |
| --- |
| ○ >0.1 μm |
| △ >0.16 μm |
| □ >0.2 μm |

Number of detected particles

Frequency of film forming

F I G. 5

| Diameter |
| --- |
| △ >0.16 μm |
| □ >0.2 μm |

Number of detected particles

Carrier flow rate (sccm)

F I G. 6

FIG. 7

FIG. 8

FIG. 9A

FIG. 9B

Flow velocity distribution in center portion of vaporization
chamber

FIG.10

FIG.11A

<u>120B</u>

F I G. 1 1 B

Temperature distribution in center portion of vaporization chamber

○ Comparative example
● Example

Bottom position P2
of comparative example

Bottom position P1
of example

Distance from nozzle (m)

F I G. 1 2

## INTERNATIONAL SEARCH REPORT

| | International application No. |
|---|---|
| | PCT/JP2005/001847 |

| A. CLASSIFICATION OF SUBJECT MATTER |
|---|
| Int.Cl⁷ H01L21/205, C23C16/448, H01L21/31 |

According to International Patent Classification (IPC) or to both national classification and IPC

| B. FIELDS SEARCHED |
|---|

Minimum documentation searched (classification system followed by classification symbols)
    Int.Cl⁷ H01L21/205, C23C16/00-16/56, H01L21/31

Documentation searched other than minimum documentation to the extent that such documents are included in the fields searched
    Jitsuyo Shinan Koho        1922-1996    Jitsuyo Shinan Toroku Koho    1996-2005
    Kokai Jitsuyo Shinan Koho  1971-2005    Toroku Jitsuyo Shinan Koho    1994-2005

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| A | JP 2000-199066 A (Gendai Denshi Sangyo Kabushiki Kaisha), 18 July, 2000 (18.07.00), Full text & US 6349887 B1 & GB 2345298 A & DE 19956472 A1 | 1-17 |
| A | JP 2002-105646 A (Shimadzu Corp.), 10 April, 2002 (10.04.02), Full text & US 2002/0043215 A1 | 1-17 |
| E,X | JP 2005-039120 A (Tokyo Electron Ltd.), 10 February, 2005 (10.02.05), Fig. 2 (Family: none) | 1,3-7 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 10 May, 2005 (10.05.05) | 24 May, 2005 (24.05.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| | International application No. |
|---|---|
| | PCT/JP2005/001847 |

C (Continuation). DOCUMENTS CONSIDERED TO BE RELEVANT

| Category* | Citation of document, with indication, where appropriate, of the relevant passages | Relevant to claim No. |
|---|---|---|
| E,X | JP 2005-113221 A (Kabushiki Kaisha Rintekku), 28 April, 2005 (28.04.05), Full text (Family: none) | 1-7,9-13,15 |
| P,X | JP 2004-107729 A (Tokyo Electron Ltd.), 08 April, 2004 (08.04.04), Fig. 6 (Family: none) | 1-4 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6310444 A
- JP 7094426 A